# EUROPÄISCHE PATENTANMELDUNG

(11) **EP 1 182 916 A2**
(43) Veröffentlichungstag der Anmeldung: **27.02.2002**
(21) Anmeldenummer: 01117575.9
(22) Anmeldetag: 20.07.2001
(51) Int. Cl.: H05K 9/00

(54) **Abschirmbauteil, zugehöriger Abschirmrahmen sowie Verfahren zu dessen Herstellung**

(30) Priorität: 25.08.2000 DE 10041791
(71) Anmelder: SIEMENS AKTIENGESELLSCHAFT, 80333 München (DE)
(72) Erfinder: Helfrich, Stefan, 02991 Tätzschwitz (DE)

(57) **Zusammenfassung**

Abschirmbauteil, zugehöriger Abschirmrahmen sowie Verfahren zu dessen Herstellung.

Ein Abschirmrahmen (FR) weist zur Abteilung von mindestens zwei Kammern (CH1, CH2) mindestens ein Abtrennelement (AT) auf. Der Abschirmrahmen (FR) und dieses zugehörige Abtrennelement (AT) bilden dabei ein einteiliges Bauteil.

## Beschreibung

Abschirmbauteil, zugehöriger Abschirmrahmen sowie Verfahren zu dessen Herstellung.

Zur elektrischen und/oder mechanischen Abschirmung bzw. Trennung von z.B. zwei Gruppen von elektrischen Bauteilen auf einer Leiterplatine ist es üblich, für jede Baugruppe jeweils ein eigenes Abschirmgehäuse vorzusehen. Ein solches Abschirmgehäuse weist dabei einen Abschirmrahmen mit einem zugehörigen Abschirmdeckel auf. Daneben sind in der Praxis bereits auch Abschirmrahmen mit zwei Kammern verwendet, die durch ein zusätzliches Abteilelement voneinander getrennt sind. Dabei sind der Abschirmrahmen sowie das Abteil- bzw. Abtrennelement als einzelne Bauteile vorgesehen, so daß der Abschirmrahmen mehrteilig ausgebildet ist. Das Zusammensetzen mehrerer Einzelbauteile zur Herstellung des Abschirmrahmens und das Einsetzen einer solchen Abtrennwand in den Abschirmrahmen ist insbesondere bei der Produktion von Leiterplatinen (z.B. für Mobilfunkgeräte), die eine Vielzahl von integrierten Schaltkreisen miniaturisiert aufweisen, erschwert. Insbesondere kostet das Zusammensetzen der einzelnen Bauteile zu viel Zeit.

Aus der DE 299 14 661 U1 ist ein Abschirmbauteil zur elektrischen und/oder mechanischen Abschirmung von Bauelementen und/oder elektrischen Schaltkreisen einer Leiterplatine mit mindestens einem Abschirmrahmen und mindestens einem zugehörigen Abschirmdeckel, wobei der Abschirmrahmen in seinem Inneren durch mindestens ein Abtrennelement in mindestens zwei Kammern unterteilt ist, und wobei der Abschirmrahmen und dieses Abtrennelement ein einteiliges Bauteil bilden. Das Abtrennelement besteht dabei aus Innenwandschenkeln zum eigentlichen Abschirmen von elektromagnetischer Strahlung und aus rechtwinklig dazu stehenden Verbindungsschenkeln, die zur Befestigung auf einem Substrat dienen. Nach einem Ausstanzen eines Abschirmrahmens einschließlich des Abtrennelements, werden die Seitenwände des Rahmens sowie die Innenwandschenkel des Abtrennelements nach oben gebogen, während die Verbindungsschenkel positionsfest an einem unteren Abschnitt der Seitenwände verbunden bleiben müssen, um bei einem späteren Befestigen auf dem Substrat ein Durchtreten von elektromagnetischer Strahlung zwischen dem Abschirmrahmen und dem Substrat zu vermeiden. Das Verbiegen der Innenwandschenkel erfolgt an speziellen Biegelinien zwischen den Innenwandschenkeln und den Verbindungsschenkeln, wobei der Übergangsbereich der Verbindungsschenkel zu den Seitenwänden positionsfest ist.

Der Erfindung liegt nun die Aufgabe zugrunde, einen Abschirmrahmen und/oder ein Abschirmbauteil mit einem solchen Abschirmrahmen zur elektromagnetischen und/oder mechanischen Abschirmung von mindestens zwei Gruppen von elektrischen und/oder mechanischen Bauelementen und/oder elektrischen Schaltkreisen zu schaffen , die mit minimiertem verfahrens- und vorrichtungstechnischen Aufwand herstellbar sind.

Diese Aufgabe wird hinsichtlich eines Abschirmbauteils gemäß den Merkmalen des Anspruchs 1, hinsichtlich eines Abschirmrahmens gemäß den Merkmalen des Anspruchs 14, und hinsichtlich eines Verfahrens zur Herstellung des Abschirmrahmens gemäß den Merkmalen des Anspruchs 15 gelöst.

Dadurch, dass der Abschirmrahmen zusammen mit dem Abtrennelement ein einteiliges, d.h. einstückiges Einzelbauteil von vornherein bildet, entfällt ein aufwendiges Zusammensetzen mehrerer Bauteile. Insbesondere ist es nicht erforderlich, ein Abtrennteil bzw. eine Abtrennwand zwischen den Seitenwänden des Abschirmrahmens im nachhinein einzusetzen, um eine Aufteilung in mindestens zwei Kammern zu erhalten. Ein solcher Einsetzvorgang wäre insbesondere bei Abschirmrahmen mit relativ kleinen geometrischen Abmessungen diffizil, wie dies z.B. bei elektromagnetischen Abschirmgehäusen für unterschiedliche Baugruppen auf Leiterplatinen für Mobilfunkgeräte, insbesondere Handy's, der Fall wäre. Durch die einstückige Ausführungsform des Abschirmrahmens mit dem mindestens einen Abtrennteil ist darüberhinaus die Lagerhaltung vereinfacht. Denn es braucht nur noch ein einziges Bauteil auf Vorrat gehalten werden, das unmittelbar in der Produktion ohne weiteres Zusammensetzen von Einzelbauteilen verwendet werden kann. Weiterhin ist ein derartiger, einteilig ausgebildeter Abschirmrahmen gegenüber einem aus mehreren Einzelteilen zusammengebauten Abschirmrahmen steifer und stabiler. Dadurch bleiben die unterschiedlichen Gruppen von Bauteilen wie z.B. auf einer Leiterplatine für ein Mobilfunktelefon in zuverlässiger Weise vor mechanischen Beanspruchungen geschützt. Selbst beim Dauereinsatz eines Mobilfunkgeräts, bei dem dieses Stößen durch Herunterfallen, Eindrücken zwischen Gepäckteilen usw. ausgesetzt ist, sind unzulässig hohe mechanische Einwirkungen auf die mindestens zwei Gruppen von Bauteilen in den Kammern des Abschirmrahmens weitgehend vermieden. Durch die verbesserte Stabilität des Abschirmrahmens bildet dieser zusammengesetzt mit einem Abschirmdeckel ein Abschirmgehäuse, mit dem eine unerwünschte Abstrahlung elektromagnetischer Felder der Bauteile in den Kammern des Abschirmrahmens nach außen, und/oder eine unerwünschte Einkopplung von elektromagnetischer Strahlung von außen nach innen, die z.B. zu einer Funktionsstörung der Bauteile führen könnten, weitgehend vermieden ist.

Dadurch, dass der Schirmrahmen und die Trennwand eine Einheit von vornherein bilden und nicht erst aus Einzelelementen zusammen gebaut werden müssen, ist es darüberhinaus ermöglicht, den erfindungsgemäßen Abschirmrahmen mit zugehöriger Abtrennwand mit einer niedrigeren Höhe zu bauen als dies bei einem konventionellen Abschirmrahmen der Fall wäre. Auf diese Weise eignet sich der erfindungsgemäße Abschirmrahmen vorzugsweise zum Einbau in sehr flache Gehäuse wie z.B. eines Mobilfunkgeräts, das ja sehr handlich sein soll.

Die Erfindung und ihre Weiterbildungen werden nachfolgend anhand von Zeichnungen näher erläutert.

Es zeigen:
- Figur 1: schematisch in perspektivischer Darstellung ein erstes Ausführungsbeispiel eines erfindungsgemäßen Abschirmrahmens im Einbauzustand für die Leiterplatine eines Mobilfunkgeräts,
- Figur 2: in schematischer Draufsicht den Abschirmrahmen nach Figur 1 unmittelbar nach seinem Ausstanzen aus einem langgestreckten Blechstreifen,
- Figur 3: in schematischer sowie perspektivischer Darstellung den Abschirmrahmen von Figur 1 nach dem Aufsetzen eines Abschirmdeckels unter Bildung eines Abschirmgehäuses, und
- Figur 4: in schematischer Darstellung eine Vorrichtung zur Herstellung des Abschirmrahmens von Figur 1.

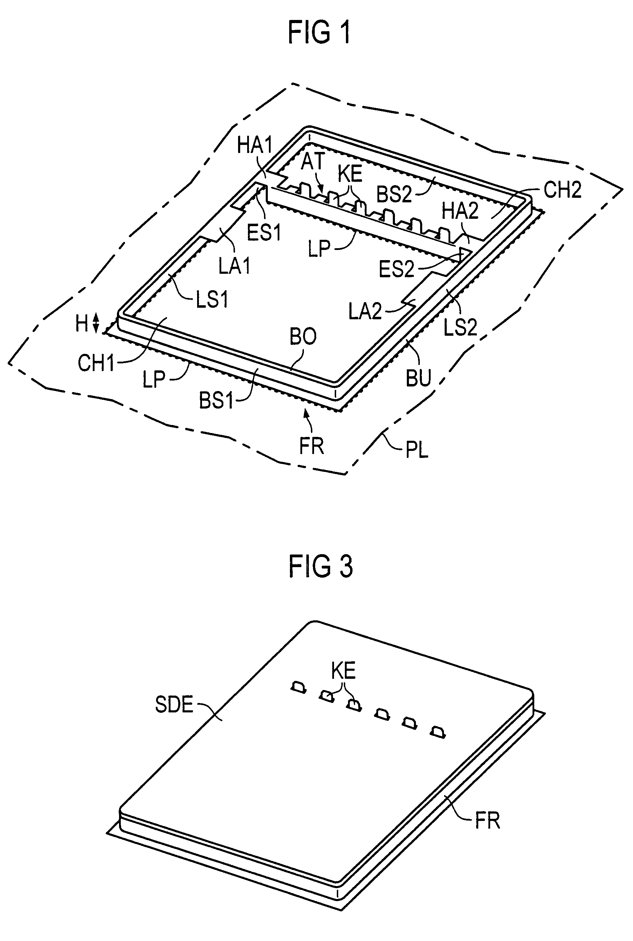

Elemente mit gleicher Funktion und Wirkungsweise sind in den Figuren 1 mit 4 jeweils mit denselben Bezugszeichen versehen.

Figur 1 zeigt schematisch in perspektiver Darstellung einen Abschirmrahmen FR für eine Leiterplatine PL, deren Umriss strichpunktiert angedeutet ist. Eine solche Leiterplatine enthält üblicherweise eine Vielzahl von integrierten Schaltkreisen, elektrischen und/oder mechanischen Bauteilen. Im vorliegenden Ausführungsbeispiel ist die Leiterplatine PL vorzugsweise zum Einbau in ein Mobilfunkgerät, insbesondere in ein sogenanntes "Handy", vorgesehen. Für sie ist im bestückten Zustand ein möglichst flacher Aufbau, d.h. eine möglichst geringe Dicke gewünscht, um sie möglichst platzsparend in ein handliches Gehäuse für das Mobilfunkgerät unterbringen zu können. Um die fertig bestückte Platine möglichst dünn halten zu können, ist es insbesondere zweckmäßig, auch ein Abschirmgehäuse für deren Bauteile und/oder Schaltkreise möglichst flach auszugestalten.

Aus diesem Grund ist es insbesondere wünschenswert, die Bauhöhe wie z.B. H des Abschirmrahmens wie z.B. FR möglichst niedrig zu halten. Dies ist vorzugsweise für die immer weiter fortschreitende Miniaturisierung der Platinen sowie Baugruppen im Inneren eines Mobilfunkgehäuses gefordert. Um dies erreichen zu können, ist der Abschirmrahmen FR von Figur 1 einteilig, d.h. als ein einstückiges Einzelbauteil ausgebildet. Er ist vorzugsweise aus einem rechteckförmigen Blechstreifen herausgeformt, insbesondere herausgestanzt. Seine beiden Breitseiten BS1, BS2, sowie seine beiden Längsseiten LS1, LS2 hängen durchgehend als ein einzelnes Bauteil von Anfang an aneinander und zwar derart, daß diese Seitenwände insgesamt einen hinsichtlich der Außenkontur sowie Innenkontur etwa recheckförmige Rahmen ergeben. Zur Unterteilung des Innenbereichs des Abschirmrahmens FR in zwei Kammern CH1, CH2 sind die beiden Längsseiten LS1, LS2 durchgängig mit einem Abtrennteil bzw. einer Abteilwand AT verbunden. Diese Abteilwand AT verläuft dabei im wesentlichen parallel zur Erstreckung der Breitseiten BS1, BS2. Die Breitseiten BS1, BS2 sowie die Längsseiten LS1, LS2 des Abschirmrahmens FR sind vorzugsweise derart vorgeformt, das sowohl ihre Oberkanten, als auch ihre Unterkanten jeweils in einer gemeinsamen Lageebene liegen. Die Seitenwände des fertigen Abschirmrahmens FR stehen nach dessen Montage auf der Platine PL im wesentlichen senkrecht zu deren etwa planen Auflagefläche. Vorzugsweise sind die Ober- und Unterkanten der Seitenwände sowohl nach außen als auch nach innen hin abgerundet. Insbesondere weist der Abschirmrahmen FR auf seine Unterseite eine Ausbuchtung BU nach außen durchgängig entlang allen vier Seitenwänden auf, so daß dort die Auflagefläche der Platine PL vergrößert ist. Dadurch wird das Aufbringen von Lötmittel bzw. Lötpaste LP erleichtert, so daß der Abschirmrahmen FR in einfacher und zuverlässiger Weise auf der Platine PL durch Anlöten fixiert werden kann. In der Figur 1 ist das Lötmittel LP durch Punkte im Bereich der Unterseite des Abschirmrahmens schematisch angedeutet.

Das Abtrennelement bzw. -teil AT ist aus demselben streifenförmigen Element, insbesondere Blechstreifen, wie die Seitenwände des Abschirmrahmens FR herausgeformt. Er ist durchgängig mit den beiden Längsseiten LS1, LS2 des Abschirmrahmens FR verbunden, so daß die vier Seitenwände LS1, LS2, BS1, BS2 des Abschirmrahmens FR und die innerhalb des Abschirmrahmens FR angeordnete Abtrennwand AT zusammen ein einteiliges, d.h. einstückiges Einzelbauteil bilden. Die Abtrennwand AT steht dabei im fertigen Einbauzustand des Abschirmrahmens FR ebenfalls im wesentlichen senkrecht zur Auflagefläche der Platine PL. Die Unterseite des Abtrennteils AT verläuft in diesem Einbauzustand im wesentlichen geradlinig und liegt dabei ebenfalls wie die Unterseiten der Seitenwände LS1, LS2, BS1, BS2 des Abschirmrahmens FR weitgehend durchgängig auf der Platinenfläche auf. Mit anderen Worten ausgedrückt heißt das, das im Montagezustand - wie dies in Figur 1 dargestellt ist - die Unterseiten der Seitenwände des Abschirmrahmens FR sowie die Unterseite des Abtrennelements AT im wesentlichen in derselben Lageebene liegen. Auf diese Weise ist sowohl für die elektrischen und/oder mechanischen Bauteile und/oder elektrischen Schaltkreise in der ersten Kammer CH1, die von Teilabschnitten der Längsseiten LS1, LS2, der Breitseite BS1 sowie der Abtrennwand AT umrahmt ist, eine erste hermetisch ringsum abschließende elektromagnetische und/oder mechanische Abschirmung bereitgestellt, wenn ein Abschirmdeckel wie z.B. SDE (vgl. Figur 3) von oben aufgesetzt wird. In entsprechender Weise sind die elektrischen und/oder mechanischen Bauteile, insbesondere elektrischen Schaltkreise auf der Platine PL innerhalb der zweiten Kammer CH2 ringsum von den Teilabschnitten der Längsseiten LS1, LS2, dem Abtrennteil AT sowie der Breitseite BS2 eingerahmt. Auf diese Weise sind die elektrischen Schaltkreise, und/oder elektrischen und/oder mechanischen Bauteile auf der Platine PL in der ersten sowie zweiten Kammer CH1, CH2 voneinander entkoppelt, d.h. bezüglich ihrer elektromagnetischen Felder und/oder mechanisch voneinander separiert.

Nach Aufbringen eines Deckelteils SDE über den Abschirmrahmen FR - wie dies in Figur 3 schematisch dargestellt ist - sind somit die Bauelemente in den beiden Kammern CH1, CH2 jeweils gruppenweise sowohl gegen die unerwünschte Auskopplung von elektromagnetischen Feldern nach außen, als auch gegen die unerwünschte Einkopplung von elektromagnetischen Feldern von außen nach innen, sowie gegen eine wechselseitige Überkopplung von elektromagnetischer Strahlung zwischen diesen beiden Gruppen von Bauteilen und/oder elektrischen Schaltkreisen weitgehend abgesichert. Figur 3 veranschaulicht dabei schematisch das fertige Abschirmgehäuse, das durch den Abschirmrahmen FR und das von oben aufgesetzte Deckelteil SDE gebildet ist.

Durch die einteilige Ausbildung des Abschirmrahmens mit den Seitenwänden LS1, LS2, BS1, BS2 sowie der Abtrennwand AT zwischen zwei gegenüberliegenden Seitenwänden ist dieser einstückig geformte Abschirmrahmen steifer und stabiler gegenüber einem konventionellen Abschirmrahmen, der lediglich aus mehreren, separaten Einzelteilen im nachhinein zusammengesetzt ist. Dadurch bleiben die unterschiedlichen Gruppen von Bauteilen, und/oder elektrischen Schaltkreisen auf einer Leiterplatine insbesondere für ein Mobilfunkgerät in zuverlässiger Weise vor mechanischen Beanspruchungen geschützt. Selbst beim Dauereinsatz eines Mobilfunkgerätes, bei dem dieses Stößen wie z.B. beim Herunterfallen, Eindrücken zwischen Gepäckteilen, Erschütterungen usw. sowie sonstigen mechanischen Belastungen ausgesetzt ist, sind unzulässig hohe mechanische Einwirkungen auf die Gruppe von elektrischen, optischen und/oder mechanischen Bauteilen in der jeweiligen Kammer des Abschirmrahmens weitgehend vermieden. Durch die verbesserte Stabilität des Abschirmrahmens bildet dieser zusammengesetzt mit einem Abschirmdeckel wie z.B. SDE in Figur 3 ein Abschirmgehäuse, mit dem eine unerwünschte Abstrahlung elektromagnetischer Felder der Bauteile in den Kammern des Abschirmrahmens nach außen, und/oder eine unerwünschte Einkopplung von elektromagnetischer Strahlung von außen nach innen, die zu einer etweigen Funktionsstörung der Bauteile bzw. Schaltkreise führen könnte, weitgehend vermieden ist. Zusätzlich oder unabhängig hiervon ist durch die einteilige Ausführung des Abschirmrahmens eine flache Bauweise ermöglicht, da das nachträgliche Zusammensetzen von Einzelbauteilen zur Bildung des Abschirmrahmens entfällt.

Der Abschirmrahmen FR von der Figur 1 weist an der Oberkante der Längsseiten LS1, LS2 im Bereich der ersten Kammer CH1 zusätzlich jeweils eine Aufsetzlasche LA1, LA2 auf gegeüberliegenden Seiten auf. Diese ist vorzugsweise rechteckförmig ausgebildet. Die jeweilige Aufsetzlasche dient zum Aufsetzen eines entsprechenden Bestückungswerkzeugs wie z.B. für die SMD-Bestückung der Platine PL. Die Aufsetzlaschen LA1, LA2 liegen dabei jeweils in derselben Lageebene wie die Oberkanten der Seitenwände LS1, LS2, BS1, BS2 des Abschirmrahmens FR.

Zur mechanischen Fixierung eines Abschirmdeckels wie z.B. SDE von Figur 3 weist die Abtrennwand AT beispielsweise eine Vielzahl von Klemmelementen KE auf, die im fertigen Einbauzustand des Abschirmrahmens FR im wesentlichen senkrecht zur Platinenoberseite abstehen. Diese Klemmelemente KE greifen in Aussparungen bzw. Öffnungen des Deckels SDE ein, so daß dieser fixierbar ist. Ein laterales Verschieben des Deckelteils SDE ist somit beim Praxiseinsatz des fertigen Mobilfunkgeräts weitgehend vermieden. Selbstverständlich ist es auch möglich, das Deckelteil SDE mit anderen mechanischen Mitteln auf dem Abschirmrahmen FR zu fixieren. Gegebenenfalls kann es auch zweckmäßig sein, das Deckelteil SDE zusätzlich oder unabhängig hiervon mit einem Klebemittel oder einem sonstigen Fixiermittel auf dem Abschirmrahmen FR zu befestigen.

Durch die einteilige Ausbildung des Abschirmrahmens FR mit mindestens zwei integrierten Kammern, die durch mindestens eine Abschirmwand voneinander separiert sind, sind Bauhöhen H von weniger als 5 mm, insbesondere zwischen 0,5 und 3 mm, ermöglicht.

Anstelle von Abschirmblech ist es selbstverständlich auch möglich, sonstige Werkstoffe zu verwenden, mit denen sich eine elektromagnetische Abschirmwirkung erzielen läßt.

Die Abtrennwand AT ist mit ihren Enden lediglich entlang einen Teilbereich ihrer Querbreite mit den einander gegenüberliegenden Seitenwänden LS1, LS2 des Abschirmrahmens FR von Figur 1 durchgängig verbunden und zwar derart, daß an den Enden der Abtrennwand im Übergangsbereich zum Abschirmrahmen Einschnitte ES1, ES2 zumindest auf einer der beiden Längsseiten der Abschirmwand gebildet sind. Aufgrund dieser Einschnitte ES1, ES2 läßt sich die Abtrennwand AT aus ihrer ursprünglichen Lageebene heraus verbiegen. Insbesondere läßt sie sich um etwa 90° aus ihrer ursprünglichen Lageebene verdrehen.

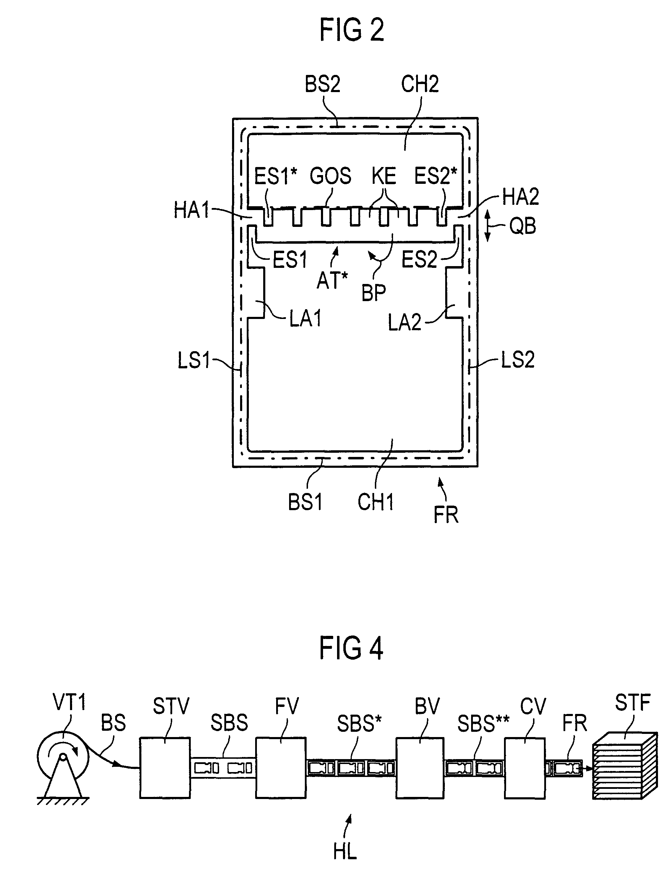

Dabei liegt die Abtrennwand unmittelbar nach dem Ausstanzen aus einem Blechstreifen im wesentlichen in derselben Lageebene wie die Oberkanten der Seitenwände LS1, LS2, BS1, BS2 oder in einer dazu parallel verlaufenden Ebene. Figur 2 zeigt schematisch in Draufsicht diese ursprüngliche Lage der Abschirmwand des Abschirmrahmens FR von Figur 1 unmittelbar nach dem Ausstanzen aus einem im wesentlichen planflächigen, langgestreckten Blechstreifen. Die Abschirmwand ist in dieser Ausgangsposition mit AT* bezeichnet. Durch die Einschnitte ES1, ES2 in der Übergangszone der Abtrennwand AT* zu den Seitenwänden LS1, LS2 ist es ermöglicht, das Abtrennelement AT* um etwa 90° senkrecht zur Zeichenebene von Figur 2 nach unten, d.h. in Richtung auf die Unterkanten des Abschirmrahmens FR hin zu verbiegen. Vorzugsweise wird die Breite des Abtrennteils AT* im wesentlichen gleich der Höhe H der Seitenwände des Abschirmrahmens FR gewählt. Die Länge der Einschnitte ES1, ES2 ist zweckmäßigerweise derart gewählt, dass das Abtrennteil AT nach seinem Umbiegen in etwa dieselbe Höhe H wie die Seitenwände des Abschirmrahmens FR aufweist und dabei mit seiner unteren Längskante etwa in derselben Lageebe wie die Unterseite des Abschirmrahmens FR liegt. Auf diese Weise ist eine einwandfreie elektromagnetische und/oder mechanische Abtrennung der beiden Kammern CH1, CH2 voneinander erreicht.

Gegebenenfalls kann es zweckmäßig sein, das Abtrennteil AT zusätzlich auch noch auf der gegenüberliegenden Seite der Einschnitte ES1, ES2 jeweils mit mindestens einem Einschnitt wie z.B. ES1*, ES2* (vgl. Figur 2) im Bereich der Enden des Abtrennteils AT* zu versehen. Zweckmäßigerweise sind diese zusätzliche Einschnitte ES1*, ES2* längsversetzt zu den Einschnitten ES1, ES2 auf der gegenüberliegenden Längsseite der Abtrennwand AT* angebracht. Erstrecken sich die Einschnitte ES1, ES1*, ES2, ES2* im wesentlichen etwa bis zur Hälfte der Querseite der Abtrennwand AT*, so läßt sich dadurch erreichen, das die Biegelinie für die Abtrennwand AT* etwa entlang deren Mittelinie verläuft. Nach dem Umbiegevorgang liegen dann die Oberkanten des Abtrennteils AT im wesentlichen in der Lageebene der Oberkante der Seitenwände des Abschirmrahmens FR und die Unterkante des Abtrennteils AT in der Lageebene der Unterkanten der Seitenwände des Abschirmrahmens FR.

Gegebenenfalls kann es auch zweckmäßig sein, die Oberkante der Abtrennwand AT im wesentlichen gradlinig auszubilden. Eine solche Oberkante GOS ist in der Figur 2 strichpunktiert mit eingezeichnet. Dadurch ergibt sich ein weitgehend bündiger Abschluß mit einem von oben aufgesetzten Deckelteil wie z.B. SDE.

Figur 4 zeigt schematisch eine Herstellungslinie HL zur fortlaufenden Herstellung einer Vielzahl von Abschirmrahmen entsprechend FR von Figur 1. Von einer Vorratstrommel VT1 wird ein langestreckter Blechstreifen BS kontinuierlich abgezogen und einer Formvorrichtung, insbesondere Ausstanzvorrichtung STV zugeführt. Mit deren Hilfe werden jeweils die beiden Kammern CH1, CH2 derart ausgestanzt, dass sich ein Blechrahmen mit einer Innen- und Außenkontur sowie einer Abtrennwand zwischen seinen beiden Kammern wie in der Draufsichtsdarstellung von Figur 2 ergibt. Der derart ausgestanzte Blechstreifen ist in der Figur 4 mit SBS bezeichnet. Er wird vorzugsweise einer weiteren Formvorrichtung FV zugeführt, der die Seitenwände des ursprünglich planen Blechstreifens BS wie in Figur 1 gezeigt umformt. Der derart umgeformte Blechstreifen SBS* wird schließlich in eine Biegeeinrichtung BV eingefahren, die jeweils die Trennwand wie z.B. AT* zwischen den jeweils zwei ausgestanzten Kammern um etwa 90° derart umbiegt, das diese Abtrennwand die beiden Kammern CH1, CH2 mit ihrer Unterkante und/oder Oberkante bezogen auf die Ober- und Unterkante der Seitenwände des Abschirmrahmens weitgehend bündig abschließt. Mit Hilfe einer nachgeordneten Schneidevorrichtung CV werden schließlich die kontinuierlich aufeinander folgenden, noch zusammenhängenden Abschirmrahmen SBS** voneinander getrennt. Ein Stapel von einzelnen Abschirmrahmen FR, die auf diese Weise jeweils fertig zum Einbau gemacht sind, ist am Ausgang der Herstellungslinie HL von Figur 5 schematisch dargestellt und mit STF bezeichnet.

## Patentansprüche

1. Abschirmbauteil (FR) zur elektrischen und/oder mechanischen Abschirmung von Bauelementen und/oder elektrischen Schaltkreisen einer Leiterplatine (PL) mit mindestens einem Abschirmrahmen (FR) und mindestens einem zugehörigen Abschirmdeckel (SDE), wobei der Abschirmrahmen (FR) in seinem Inneren durch mindestens ein Abtrennelement (AT) in mindestens zwei Kammern (CH1, CH2) zur separaten Aufnahme von mindestens zwei Gruppen von Bauelementen und/oder Schaltkreisen unterteilt ist, und wobei der Abschirmrahmen (FR) und dieses Abtrennelement (AT) ein einteiliges Bauteil bilden,
**dadurch gekennzeichnet,**
**dass** das Abtrennelement (AT) einen jeweiligen Übergangsbereich zu Seitenwänden (LS1, LS2) des Abschirmrahmens (FR) mit einem verringerten Querschnitt aufweist, wobei das Abtrennelement (AT) in dem Übergangsbereich relativ zu dem Abschirmrahmen (FR) verdrehbar ist.

2. Abschirmbauteil nach Anspruch 1,
**dadurch gekennzeichnet,**
**dass** für den Abschirmrahmen (FR), dessen Abtrennelement (AT), und/oder den zugehörigen Abschirmdeckel (SDE) ein metallischer Werkstoff gewählt ist.

3. Abschirmbauteil nach einem der vorhergehenden Ansprüche,
**dadurch gekennzeichnet,**
**dass** der Übergangsbereich des Abtrennelements (AT) durch einen ersten Quereinschnitt (ES1, ES2) gebildet ist , so dass sich das Abtrennelement aus seiner ursprünglichen Lageebene (AT*) in eine Einbauposition (AT) verbiegen lässt.

4. Abschirmbauteil nach Anspruch 3,
**dadurch gekennzeichnet,**
**dass** die Länge des Einschnitts (ES1, ES2) derart gewählt ist, dass das Abtrennelement (AT) nach seinem Umbiegen in eine Einbauposition etwa dieselbe Höhe (H) wie die Seitenwände (BS1, BS2, LS1, LS2) des Abschirmrahmens (FR) aufweist und dabei mit seiner unteren und oberen Längskante in etwa in derselben Lageebene wie die Ober- und Unterseiten der Seitenwände (BS1, BS2, LS1, LS2) des Abschirmrahmens (FR) liegt.

5. Abschirmbauteil nach einem der Ansprüche 3 oder 4,
**dadurch gekennzeichnet,**
**dass** das Abtrennelement (AT) ferner einen jeweiligen zweiten Quereinschnitt (ES1*,ES2*) aufweist, der in der nähe des ersten Quereinschnitts (ES1, ES2) auf der gegenüberliegenden Seite des Abtrennelements (AT) diesbezüglich vorgesehen ist.

6. Abschirmbauteil nach einem der vorhergehenden Ansprüche,
**dadurch gekennzeichnet,**
**dass** der Abschirmrahmen (FR) im Querschnitt betrachtet bezüglich seiner Außen- und Innenkontur im wesentlichen rechteckförmig ausgebildet ist.

7. Abschirmbauteil nach einem der vorhergehenden Ansprüche,
**dadurch gekennzeichnet,**
**dass** das Abtrennelement (AT) im wesentlichen rechteckförmig ausgebildet ist.

8. Abschirmbauteil nach einem der vorhergehenden Ansprüche,
**dadurch gekennzeichnet,**
**dass** das Abtrennelement (AT) im fertigen Einbauzustand im wesentlichen parallel zu zwei einander gegenüberliegenden Seitenwänden (BS1, BS2) des Abschirmrahmens (FR) verläuft.

9. Abschirmbauteil nach einem der vorhergehenden Ansprüche,
**dadurch gekennzeichnet,**
**dass** die beiden Kammern (CH1, CH2) durch Ausstanzen eines Blechstreifens derart gebildet sind, dass das Abtrennelement (AT*) als mit zwei einander gegenüberliegenden Seitenwänden (LS1, LS2) des Abschirmrahmens (FR) durchgängig verbundener Streifen übrig bleibt.

10. Abschirmbauteil nach Anspruch 9,
**dadurch gekennzeichnet,**
**dass** das Abtrennelement (AT*) nach dem Ausstanzen der Kammern (CH1, CH2) im wesentlichen plan in derjenigen Lageebene liegt, die von den Oberseiten des geformten Abschirmrahmens (FR) umfasst sind.

11. Abschirmbauteil nach einem der vorhergehenden Ansprüche,
**dadurch gekennzeichnet,**
**dass** der Abschirmrahmen (FR) derart geformt ist, dass jede seiner Seitenwände (BS1, BS2, LS1, LS2) und/oder das jeweilige Abtrennelement (AT) quer, insbesondere in erster Näherung senkrecht, zur Auflageebene der Leiterplatine (PL) aufsetzbar ist.

12. Abschirmbauteil nach einem der vorhergehenden Ansprüche,
**dadurch gekennzeichnet,**
**dass** die Oberseiten und/oder Unterseiten des Abschirmrahmens (FR) im wesentlichen in derselben Lageebene angeordnet sind.

13. Abschirmbauteil nach einem der vorhergehenden Ansprüche,
**dadurch gekennzeichnet,**
**dass** am Abschirmrahmen (FR) und /oder an dessem Abtrennelement (AT) mindestens ein Befestigungsmittel (KE) zum Fixieren des Abschirmdeckels (SDE) vorgesehen ist.

14. Abschirmrahmen (FR) mit mindestens vier Seitenwänden (LS1, LS2, BS1, BS2) und mindestens einem Abtrennelement (AT) zur Bildung von mindestens zwei Kammern (CH1, CH2), wobei das Abtrennelement (AT) mit den Seitenwänden (LS1, LS2, BS1, BS2) derart verbunden ist, dass ein einteiliges Bauteil gebildet ist, insbesondere nach einem der vorhergehenden Ansprüche,
**dadurch gekennzeichnet,**
**dass** das Abtrennelement (AT) einen jeweiligen Übergangsbereich zu den Seitenwänden (LS1, LS2) des Abschirmrahmens (FR) mit einem verringerten Querschnitt aufweist, wobei das Abtrennelement (AT) in dem Übergangsbereich relativ zu dem Abschirmrahmen (FR) verdrehbar ist.

15. Verfahren zur Herstellung eines Abschirmrahmens (FR) nach einem der vorhergehenden Ansprüche, mit folgenden Schritten:
Formen eines Abschirmrahmens (FR) mit mindestens einem Abtrennelement (AT) zur Abteilung mindestens zweier Kammern (CH1, CH2) als einteiliges Bauteil aus einem langgestreckten, streifenförmigen Element (BS), wobei das Abtrennelement (AT) einen jeweiligen Übergangsbereich zu Seitenwänden (LS1, LS2) des Abschirmrahmens (FR) mit einem verringerten Querschnitt aufweist, und das Abtrennelement (AT) in dem Übergangsbereich relativ zu dem Abschirmrahmen (FR) verdrehbar ist;
Verdrehen des Abtrennelements (AT) in eine Einbauposition.

16. Verfahren nach Anspruch 15,
**dadurch gekennzeichnet,**
**dass** der Abschirmrahmen (FR) zusammen mit seinem Abtrennelement (AT) derart aus dem streifenförmigen Element (BS) herausgestanzt wird, dass das Abtrennelement (AT*) zunächst in einer Ebene liegt, die im wesentlichen parallel zur Lageebene der Oberkanten der Seitenwände (BS1, BS2, LS1, LS2) des Abschirmrahmens (FR) angeordnet ist.

17. Verfahren nach Anspruch 16,
**dadurch gekennzeichnet,**
**dass** das Abtrennelement (AT*) aus seiner ursprünglichen Lageebene um etwa 90° nach unten in Richtung auf die Unterkanten des Abschirmrahmens (FR) in eine Einbauposition gebogen wird.

18. Verfahren nach einem der Ansprüche 15 mit 17,
**dadurch gekennzeichnet,**
**dass** der Abschirmrahmen (FR) mit seinem Abtrennelement (AT) aus dem streifenförmigen Element (BS) herausgeschnitten wird, und dass das Abtrennelement (AT*) aus seiner ursprünglichen Lageebene so in eine Einbauposition gebogen wird, dass es im Einbauzustand im wesentlichen parallel zu zwei gegenüberliegenden Seitenwänden (BS1, BS2) des Abschirmrahmens (FR) angeordnet wird.
